# EUROPEAN PATENT APPLICATION

(11) **EP 4 498 602 A1**
(43) Date of publication of application: **29.01.2025**
(21) Application number: 24184582.5
(22) Date of filing: 26.06.2024
(51) Int. Cl.: H03K 17/082, B64D 27/33, G01R 31/00, G01R 31/40, B60L 50/51, B60L 50/60, B64D 27/02, G01R 31/26, G01R 31/64, H02M 1/32, H03K 17/18

(54) **POWER ELECTRONICS CONVERTER**

(30) Priority: 25.07.2023 GB 202311386
(71) Applicant: Rolls-Royce plc, London N1 9FX (GB)
(72) Inventor: Mohamed Halick, Mohamed Sathik, Derby, DE24 8BJ (GB); Nadarajan, Sivakumar, Derby, DE24 8BJ (GB); Vaiyapuri, Viswanathan, Derby, DE24 8BJ (GB); Gupta, Amit, Derby, DE24 8BJ (GB)
(74) Representative: Rolls-Royce plc

(57) **Abstract**

A power electronics converter 206, 207 connectable, on a DC-side, to a DC electrical network 210, 330 and either, on an AC-side, to an electrical machine 213, 310 coupled to a drive shaft of an engine or propulsor, or, on a second DC-side, to a battery pack 203. The power electronics converter includes: a power conversion unit 320 including a plurality of semiconductor switching elements 322, 324 and a DC-link 328; and a gate driver unit 340, configured to control the semiconductor switching elements so that the power conversion unit: inverts DC power received from the DC electrical network 330 to AC power and provides the AC power to the electrical machine 310, rectifies AC power received from the electrical machine to DC power and provides the DC power to the DC electrical network, or performs DC-DC conversion between the DC-electrical network and the battery pack; wherein the gate driver unit 340 includes an equipment health monitoring component 350, configured to collect data indicative of the health of the power electronics converter and/or components thereof.

## Description

### FIELD

The present disclosure relates to a power electronics converter, electrical power system, aircraft power and propulsion system, aircraft, method, and gate driver unit.

### BACKGROUND

In aerospace, aircraft and their power and propulsion systems are becoming increasingly electric in their design. So-called `more electric engines' (MEEs) and `more electrical aircraft' (MEAs) derive all or substantially all of their propulsive thrust from turbomachinery but make greater use of electrical power as compared to conventional platforms. They may, for example, use electrical power to power auxiliary systems which have previously been powered mechanically or pneumatically, or may use spool-coupled electrical machines or motors to transfer power to, from, and between engine spools to provide improvements in engine operability and efficiency. In hybrid electric aircraft the propulsive thrust is derived from engines (e.g., gas turbine engines) and from other sources, typically batteries and/or fuel cells which supply electrical power to engine- or propulsor-coupled electrical machines.

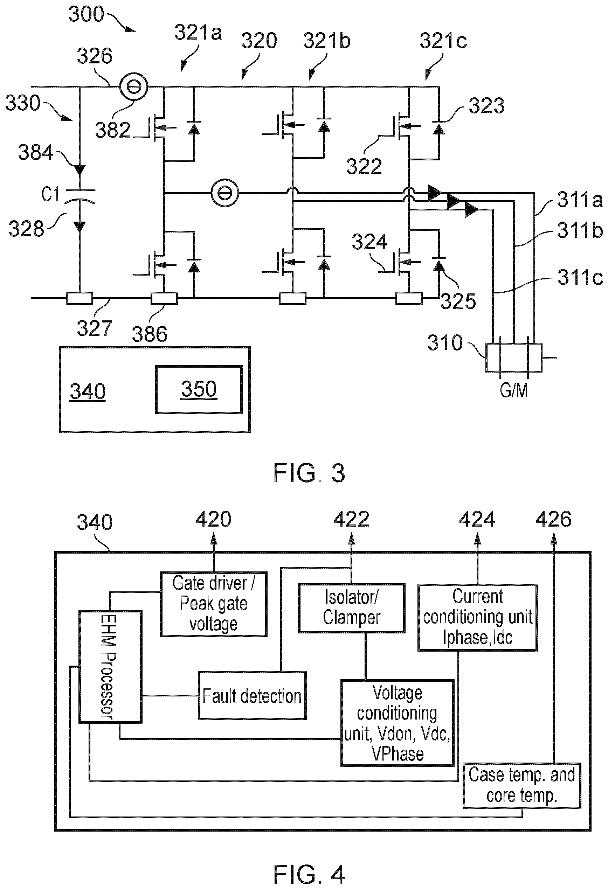

Some proposed electric or hybrid electric platforms include DC electrical networks which receive electrical power from engine-driven electrical machines via AC to DC converters (i.e., rectifiers). The circuit of FIG. 3 illustrates such a typical arrangement in which a three-phase permanent magnetic electrical machine, which may be coupled with and drive a spool of a gas turbine engine, is connected with a DC network via a two-level AC/DC converter.

The power electronic converters are a key component in these systems, and are made up of components including power devices (e.g., MOSFETs), capacitors, carriers (e.g., PCBs) for carrying and interconnecting components, and a cooling system. Amongst these components, the power devices and capacitors are typically considered the weakest link. It is known that, of all failures of power electronic converters, the capacitors and power devices contribute to around 50% of the total failures. Failures in these components are mainly due to environmental and/or electrical stress, which causes periodic wear-out leading to component failure.

The present disclosure was arrived at in light of the above considerations.

### SUMMARY

In a first aspect, embodiments of the invention provide a power electronics converter connectable, on a DC-side, to a DC electrical network and either, on an AC-side, to an electrical machine coupled to a drive shaft of an engine or propulsor, or, on a second DC-side, to a battery pack, the power electronics converter including:
a power conversion unit including a plurality of semiconductor switching elements and a DC-link; and
a gate driver unit, configured to control the semiconductor switching elements so that the power conversion unit: inverts DC power received from the DC electrical network to AC power and provides the AC power to the electrical machine, rectifies AC power received from the electrical machine to DC power and provides the DC power to the DC electrical network, or performs DC-DC conversion between the DC electrical network and the battery pack;
wherein the gate driver includes an equipment health monitoring component, configured to collect data indicative of the health of the power electronics converter and/or components thereof.

Such a power electronics converter demonstrates increased reliability as the integration of the equipment health monitoring component with the gate driver reduces the time between the determination of a fault and the remediation. Further health status and resulting useful life (RUL) estimation of the power conversion system can be enabled through the integration of the condition monitoring system and failure prognosis capability in the gate driver.

The equipment health monitoring component may be configured to transmit the collected data, or data derived and/or calculated using the collected data to a main controller of the power electronics converter, aircraft power system and/or aircraft.

The equipment health monitoring component may be configured to collect data indicative of one or more of: an on-state voltage of the power conversion unit and/or components thereof; a gate voltage of one or more of the plurality of semiconductor switching elements; a temperature of the power conversion unit and/or components thereof; a ripple voltage of a capacitor of the DC-link; a ripple current of a capacitor of the DC-link; a DC-link current; a DC-link voltage; a phase-to-phase voltage of the AC-side; and a phase current in the AC-side.

The equipment health monitoring component may be configured to: utilise the collected data to prognosticate the health of the power electronics converter and/or components thereof; and/or utilise the collected data to diagnose faults in the power electronics converter and/or components thereof.

Prior to utilising the collected data, the equipment health monitoring component may be configured to pre-process the collected data. Pre-processing the data may include one or more of: an integration process; an amplification process; and a filtering process.

The equipment health monitoring component may be configured to take remedial action based on the prognostication and/or diagnosis of a fault. For example, the equipment health monitoring component may cause the semiconductor switching elements to cease operation, to instruct that a power flow through the power electronics converter cease or decrease in amplitude.

The power electronics converter may include one or more sensors which generate the data collected by the equipment health monitoring component. The one or more sensors may include one or more of: a first current sensor, located on the DC side of the power electronics converter and configured to sense current flowing therethrough; a second current sensor, located on the AC side of the power electronics converter and configured to sense current flowing therethrough; a first voltage sensor, located on the DC side of the power electronics converter and configured to sense a voltage of the DC side; a second voltage sensor, located on the AC side of the power electronics converter and configured to sense a voltage of the AC side; a first temperature sensor located proximal to one or more of the semiconductor switching elements, configured to measure a temperature of a heatsink thereof; and a second temperature sensor, located proximal to a capacitor of the DC-link, and configured to measure a temperature of a case thereof. The first and/or second current sensors may be indirect current sensors. For example, they may be Rogowski coils.

The equipment health monitoring component may be configured to utilise the collected data to derive further data related to the power electronics converter and/or components thereof. This further data can also be used in prognostication or diagnosis. The equipment health monitoring component may be configured to use one or more measured temperatures to derive one or both of an estimated junction temperature of the or each semiconductor switching element and a core temperature of a capacitor of the DC-link.

The, or each, semiconductor switching element may be a metal-oxide-semiconductor-field-effect transistor (MOSFET) switching element, an integrated gate bipolar transistor (IGBT), silicon carbide based transistor (for example a SiC MOSFET), or a high electron mobility (HEMT) transistor (for example a gallium nitride based transistor). The capacitor in the DC-link may be an aluminium electrolytic capacitor, a film capacitor, a ceralink capacitor, or a ceramic capacitor.

The power electronics converter may be configured as a DC-DC converter, DC-AC converter, AC-DC converter, multi-level converter, matrix converter, or multi-phase converter. The equipment health monitoring component may be configured to detect permanent degradations of components for reconfiguration (e.g. for power modules and capacitors). The equipment health monitoring component may be configured to detect permanent short circuit faults, and us this in reconfiguring the power electronics converter. Where the power electronics converter is configured as a DC-DC converter (e.g. when it is connected on one DC-side to the DC electrical network and on another DC-side to the battery pack) it may be operable as a buck, boost, buck-boost, or Cuk converter. In such instances, the equipment health monitoring component may be configured to sense or receive current measurements indicative of a current between a voltage source and the switching element and/or voltage measurements indicative of a voltage dropped across the switching element.

The equipment health monitoring component may be configured to detect over temperature, short circuit current, and over current conditions in the power conversion unit and DC-link (e.g. a capacitor of the DC-link). The power electronics converter, for example through the equipment health monitoring component, may be configured to limit the fault current when it increases above a threshold limit. The equipment health monitoring component may be configured to estimate a remaining useful life of the power electronics converter and/or components thereof, and may be provide this estimation to an external component (e.g., main controller, cloud computing platform etc.). The equipment health monitoring component may be configured to estimate and provide information to the thermal management system for the power electronics converter and/or components thereof.

The power electronics converter may be located within a grid-connected inverter (e.g., for solar, fuel cell, and wind power generation). The power electronics converter may be used with a variable speed drive, for example for controlling pumps, rolling mills etc. As a DC-DC converter, the power electronics converter may be used in various switch mode power supplies, or as a solid state power controller.

In a second aspect, embodiments of the invention provide an electrical power system comprising:
an electrical machine coupled to a drive shaft of an engine; and/or a battery pack;
the electrical power system further comprising :
   a DC electrical network; and
   the power electronics converter of the first aspect including any one or any combination of the optional features set out with reference thereto, connected on the DC-side to the DC electrical network and either, on the AC-side, to the electrical machine or, on the second DC-side, to the battery pack.

In a third aspect, embodiments of the invention provide an aircraft power and propulsion system comprising: the electrical power system according to the second aspect, wherein the electrical machine of the electrical power system is mechanically coupled with a fan.

In a fourth aspect, embodiments of the invention provide an aircraft comprising the power and propulsion system of the third aspect. The aircraft may be an electric aircraft or a hybrid-electric aircraft.

In a fifth aspect, embodiments of the invention provide a method of controlling an electrical power system, the electrical power system comprising an electrical machine, and/or a battery pack, the electrical power system further comprising: a DC electrical network, and a power electronics converter connected between either the electrical machine and the DC electrical network or the battery pack and the DC electrical network, the method comprising:
controlling, by a gate driver unit, the switching of semiconductor switching elements of a power conversion unit of the power electronics converter to: invert a DC input form the DC electrical network to an AC output and supply the AC output to the electrical machine, rectify an AC power received from the electrical machine to DC power and provide the DC power to the DC electrical network, or perform DC-DC conversion between the DC electrical network and the battery pack; and
collecting, by an equipment health monitoring component which forms a part of the gate driver unit, data indictive of the health of the power electronics converter and/or components thereof.

In a sixth aspect, embodiments of the invention provide a gate driver unit for an electrical power system configured to: control switching of a plurality of semiconductor switching elements of a power conversion unit of a power electronics converter so as to: invert DC power received by the power electronics converter from a DC electrical network to AC power and provide the AC power to an electrical machine, rectify AC power received from the electrical machine to DC power and provide the DC power to the DC electrical network, or perform DC-DC conversion between the DC electrical network and a battery pack;
the gate driver unit further comprising an equipment health monitoring component configured to collect data indicative of the health of the power electronics converter and/or components thereof.

The invention includes the combination of the aspects and preferred features described except where such a combination is clearly impermissible or expressly avoided.

Further aspects of the present invention provide: a computer program comprising code which, when run on a computer, causes the computer to perform the method of the fifth aspect; a computer readable medium storing a computer program comprising code which, when run on a computer, causes the computer to perform the method of the fifth aspect; and a computer system programmed to perform the method of the fifth aspect.

### BRIEF DESCRIPTION OF THE DRAWINGS

Embodiments will now be described by way of example only with reference to the accompanying drawings, in which:
**FIG. 1** shows a general arrangement of a turbofan engine for an aircraft;
**FIG. 2A** is a schematic illustration of a hybrid electric aircraft propulsion system;
**FIG. 2B** illustrates an electrically powered propulsor such as may be used in a hybrid electric propulsion system;
**FIG. 3** illustrates a portion of an exemplary electrical power system in which a converter connects a DC network with a 3-phase electrical machine;
**FIG. 4** is a schematic of a gate driver unit;
**FIG. 5** is a schematic of a current sensor;
**FIG. 6** is a flow chart;
**FIG. 7** shows the waveforms of a phase current measurement;
**FIG. 8** is a flow chart;
**FIG. 9** is a flow chart;
**FIG. 10** shows a short circuit test;
**FIG. 11** is a block diagram of a component of the gate driver unit;
**FIG. 12** is a flow chart;
**FIG. 13** shows typically acquired data for the on-state voltage, on-state resistance, and junction temperature of a power device;
**FIG. 14** is a block diagram of a component of the gate driver unit;
**FIG. 15** is a flow chart; and
**FIG. 16** shows experimental validation data of ESR and capacitance of the DC-link capacitor.

### DETAILED DESCRIPTION

Aspects and embodiments of the present invention will now be discussed with reference to the accompanying figures. Further aspects and embodiments will be apparent to those skilled in the art.

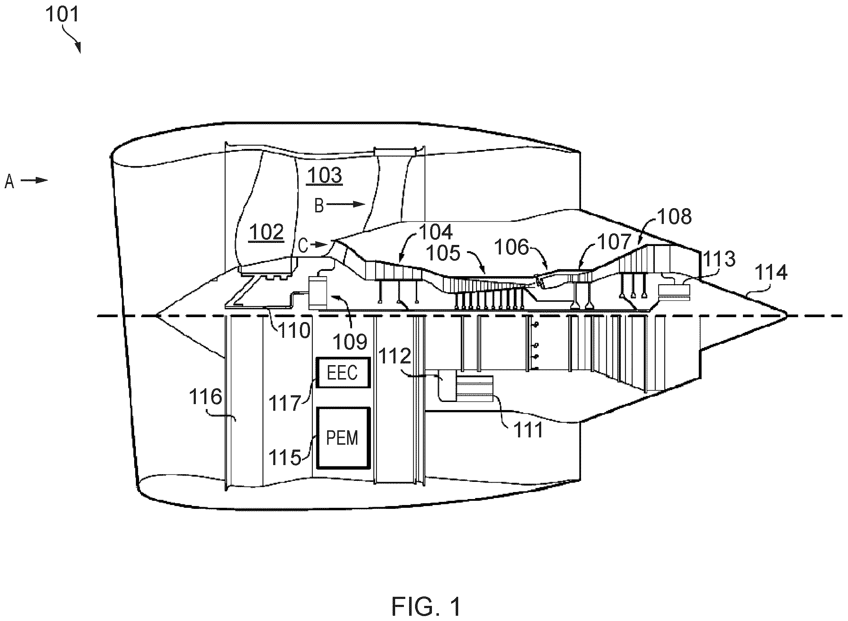

A general arrangement of an engine 101 for an aircraft is shown in FIG. 1. The engine 101 is of a turbofan configuration, and thus comprises a ducted fan 102 that receives intake air A and generates two pressurised airflows: a bypass flow B which passes axially through a bypass duct 103 and a core flow C which enters a core gas turbine.

The core gas turbine comprises, in axial flow series, a low-pressure compressor 104, a high-pressure compressor 105, a combustor 106, a high-pressure turbine 107, and a low-pressure turbine 108.

In operation, the core flow C is compressed by the low-pressure compressor 104 and is then directed into the high-pressure compressor 105 where further compression takes place. The compressed air exhausted from the high-pressure compressor 105 is directed into the combustor 106 where it is mixed with fuel and the mixture is combusted. The resultant hot combustion products then expand through, and thereby drive, the high-pressure turbine 107 and in turn the low-pressure turbine 108 before being exhausted to provide a small proportion of the overall thrust.

The high-pressure turbine 107 drives the high-pressure compressor 105 via an interconnecting shaft. The low-pressure turbine 108 drives the low-pressure compressor 104 via another interconnecting shaft. Together, the high-pressure compressor 105, high-pressure turbine 107, and associated interconnecting shaft form part of a high-pressure spool of the engine 101. Similarly, the low-pressure compressor 104, low-pressure turbine 108, and associated interconnecting shaft from part of a low-pressure spool of the engine 101. Such nomenclature will be familiar to those skilled in the art. Those skilled in the art will also appreciate that whilst the illustrated engine has two spools, other gas turbine engines have a different number of spools, e.g., three spools.

The fan 102 is driven by the low-pressure turbine 108 via a reduction gearbox in the form of a planetary-configuration epicyclic gearbox 109. Thus, in this configuration, the low-pressure turbine 108 is connected with a sun gear of the gearbox 109. The sun gear is meshed with a plurality of planet gears located in a rotating carrier, which planet gears are in turn meshed with a static ring gear. The rotating carrier drives the fan 102 via a fan shaft 110. It will be appreciated that in alternative embodiments a star-configuration epicyclic gearbox (in which the planet carrier is static, and the ring gear rotates and provides the output) may be used instead, and indeed that the gearbox 109 may be omitted entirely so that the fan 102 is driven directly by the low-pressure turbine 108.

It is increasingly desirable to facilitate a greater degree of electrical functionality on the airframe and on the engine. To this end, the engine 101 of FIG. 1 comprises one or more rotary electrical machines, generally capable of operating both as a motor and as a generator. The number and arrangement of the rotary electrical machines will depend to some extent on the desired functionality. Some embodiments of the engine 101 include a single rotary electrical machine 111 driven by the high-pressure spool, for example by a core-mounted accessory drive 112 of conventional configuration. Such a configuration facilitates the generation of electrical power for the engine and the aircraft and the driving of the high-pressure spool to facilitate starting of the engine in place of an air turbine starter. Other embodiments, including the one shown in FIG. 1, comprise both a first rotary electrical machine 111 coupled with the high-pressure spool and a secondary rotary electrical machine 113 coupled with the low-pressure spool. In addition to generating electrical power and the starting of the engine 101, having both first and secondary rotary machines 111, 113 connected by power electronics can facilitate the transfer of mechanical power between the high- and low-pressure spools to improve operability, fuel consumption, etc.

As mentioned above, in FIG. 1 the first rotary electrical machine 111 is driven by the high-pressure spool via a core-mounted accessory drive 112 of conventional configuration. In alternative embodiments, the first electrical machine 111 may be mounted coaxially with the turbomachinery in the engine 101. For example, the first electrical machine 111 may be mounted axially in line with the duct between the low- and high-pressure compressor 104 and 105. In FIG. 1, the second electrical machine 113 is mounted in the tail cone 114 of the engine 101 coaxially with the turbomachinery and is coupled to the lo-pressure turbine 108. In alternative embodiments, the second rotary electrical machine 113 may be located axially in line with the low-pressure compressor 104, which may adopt a bladed disc or bladed drum configuration to provide space for the second rotary electrical machine 113. It will of course be appreciated by those skilled in the art that any other suitable location for the first and (if present) second electrical machines may be adopted.

The first and second electrical machines 111, 113 are connected via power electronics. Extraction of power from or application of power to the electrical machines is performed by a power electronics module (PEM) 115. In the present embodiment, the PEM 115 is mounted on the fan case 116 of the engine 101, but it will be appreciated that it may be mounted elsewhere such as on the core of the gas turbine, or in the vehicle to which the engine 101 is attached, for example.

Control of the PEM 115 and of the first and second electrical machines 111 and 113 is in the present example performed by an engine electronic controller (EEC) 117. In the present embodiment, the EEC 117 is a full-authority digital engine controller (FADEC), the configuration of which will be known and understood by those skilled in the art. It therefore controls all aspects of the engine 101, i.e., both of the core gas turbine engine and the first and second electrical machines 111 and 113. In this way, the EEC 117 may holistically respond to both thrust demand and electrical power demand.

The one or more rotary electrical machines 111, 113 and the power electronics 115 may be Configured to output to or receive electrical power from one, two, or more DC busses. The DC busses allow for the distribution of electrical power to other engine electrical loads and to electrical loads on the airframe.

Those skilled in the art will appreciate that the gas turbine engine 101 described above may be regarded as a `more electric' gas turbine engine because of the increased role of the electrical machines 111, 113 compared with those of conventional gas turbines.

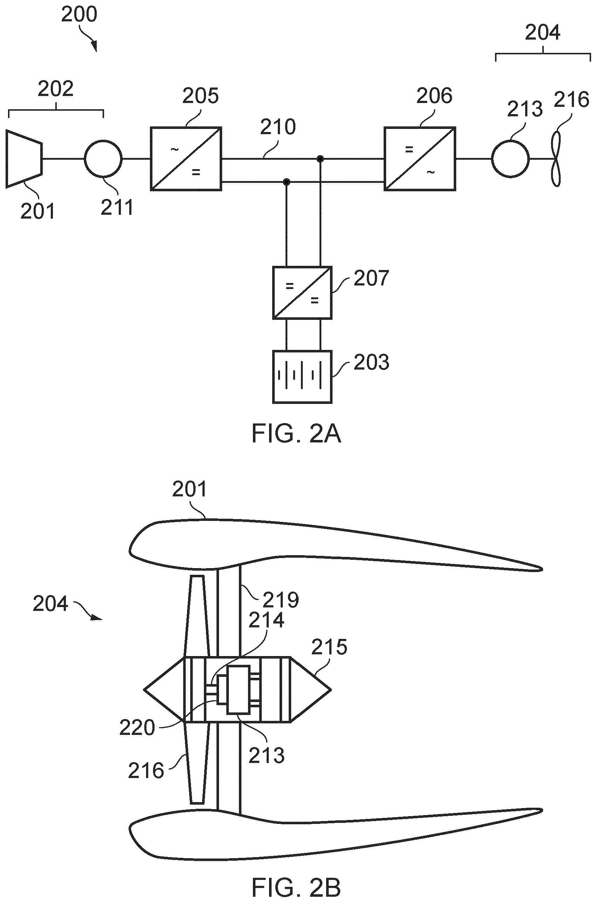

FIG. 2A illustrates an exemplary propulsion system 200 of a hybrid electric aircraft. The propulsion system 200 includes a generator set 202 comprising a generator-engine 201 and electrical generator 211, and a battery pack 203. Both the generator set 202 and the battery pack 203 are used as energy sources to power a motor-drive propulsor 204, an example of which is shown in FIG. 2B.

The illustrated propulsion system 200 further comprises an AC/DC converter 205, a DC distribution bus 210, a DC/AC converter 206, and a DC/DC converter 207. It will be appreciated that whilst one generator 202 and one propulsor 204 are illustrated in this example, a propulsion system 200 may include more than one generator set 202 and/or one or more propulsor 204.

A shaft or spool of the generator-engine 201 is coupled to and drives the rotation of a shaft of the generator 211 which thereby produces alternating current. The AC/DC converter 205, which faces the generator 211, converts the alternating current into direct current which is fed to various electrical systems and loads via the DC distribution bus 210. These electrical systems include non-propulsive loads (not shown in FIG. 2A) and the motor 213 which drives the propulsor 204 via the DC/AC converter 206.

The battery pack 203, which may be made up of a number of battery modules connected in series and/or parallel, is connected to the DC distribution bus 210 via the DC/DC converter 207. The DC/DC converter 207 converts between a voltage of the battery pack 203 and a voltage of the DC distribution bus 210. In this way, the battery pack 203 can replace or supplement the power provided by the generator set 202 (by discharging and thereby feeding the DC distribution bus 210) or can be charged using the power provided by the generator set 202 (by being fed by the DC distribution bus 210).

Referring to FIG. 2B, in this example the propulsor 204 takes the form of a ducted fan. The fan 216 is enclosed within a fan duct 219 defined within a nacelle 211 and is mounted to a core nacelle 215. The fan 216 is driven by the electrical machine 213 via a drive shaft 214, both of which may also be thought of as components of the propulsor 204. In this embodiment, a gearbox 220 is provided between the electrical machine 213 and the drive shaft 214.

The electrical machine 213 is supplied with electrical power from a power source, for example the generator set 202 and/or the battery 203 via the DC bus 210. The electrical machine 213 of the propulsor is a permanent magnet electrical machine. The electrical machine 211 of the generator set 202 may be of any suitable time, for example a permanent magnet synchronous type.

Those skilled in the art will recognise the propulsion system 200 of FIGS. 2A-B to be of the series hybrid type. Other hybrid electric propulsion systems are of the parallel type, while still others are of the turboelectric type or have features of more than one type. The configuration of the more electric engine 101 of FIG. 1 may be considered to be similar to a parallel hybrid system, with the main distinction being the roles of the electrical machines. For example, the electrical machines of a more electric engine are generally only used in motor mode to start the engine and to improve engine operability, whereas the electric machines of a parallel hybrid propulsion system are used to meaningfully motor the spools and add to the amount of propulsive thrust produced by the turbomachinery.

Those skilled in the art will also appreciate that the hybrid architecture illustrated in FIG. 2A is only one example, and other architectures are known and will occur to those skilled in the art.

FIG. 3 illustrates a portion of an electrical power system 300 such as may be used in the aircraft and engine systems described above with reference to FIG. 1 and FIGS. 2A-B. The electrical power system 300 includes an electrical machine 310 operable: (i) as a motor to transform received AC power to generate motion of the rotor; or (ii) as a generator to transform motion of the rotor to generate AC power. The electrical power system 300 also includes a DC/AC power electronics converter 320 operable, in normal use, to invert DC power received from DC electrical network 330 (for example DC network 210 in FIG. 2A) and output AC power to the electrical machine 310, and a gate driver unit 340 which exercises control over the electrical power system 300 including the converter 320. The gate driver unit includes an equipment health monitoring component 350, the function of which is described in detail below.

In this example, the electrical machine 310 is a three-phase permanent magnet machine which receives three phases of AC power, provided by the converter 320, through three phase connections 311a, 311b, 311c. It will however be understood that other numbers of phases (e.g., four) and other connection arrangements could be used. The electrical machine 310 can be of any type and configuration suitable for the application requirements. The electrical machine 310 may be specifically configured as a motor, or it may be operable in both motor and generator modes (e.g., where the electrical machine 310 is a 'starter-generator' of a gas turbine engine).

The illustrated power electronics converter 320 is a two-level, three-phase full-bridge rectifier with metal-oxide-semiconductor field-effect transistors (MOSFETs). It includes three phase legs 321a, 321b, 321c, each of which is connected to a corresponding one of the phase connections 311a, 311b, 311c to which it provides AC power. Each phase leg 321a, 321b, 321c includes two branches: a first (upper) branch which includes a transistor 322 and associated diode 323 connected in anti-parallel with the transistor 322 and a second (lower) branch which includes a transistor 324 and associated diode 325 connected in anti-parallel with the transistor 324. The associated diodes may be implemented either as the MOSFET's inherent body diode, or as discrete, external (to the MOSFET) diodes. Generally speaking, it is preferable to use discrete, external, anti-parallel diodes, as the additional diode may permit e.g., faster switching, a higher current rating, and a lower on-state voltage drop. The upper branch of each phase leg 321a, 321b, 321c is connected with a first DC input 326. The lower branch of each phase leg 321a, 321b, 321c Is connected with a second DC input 327. The first and second DC inputs 326, 327 connect with the DC electrical supply network 330, whereby the DC electrical 330 supplies DC electrical power to the converter 320. A DC-link capacitor 328 is also shown, the function of which will be familiar to those skilled in the art of power electronics.

Whilst a two-level, three-phase rectifier 320 with MOSFETs is illustrated, this is not intended to limit the disclosure. Different numbers of phases and different converter topologies may be used. The MOSFETs may be, e.g., wide band gaps semiconductor MOSFETs such as Silicon Carbide (SiC) MOSFETs. The converter 320 may also utilise another type of transistor, for example gallium nitride HEMTs (high electron mobility transistors).

In normal operation of the converter 320 as an inverter, the gate driver unit 340 uses pulse width modulation, providing signals to a gate of each transistor to control the switching of the transistors and so switch the current between the first and second DC inputs 326, 327 to affect suitable inversion of the DC to AC.

The electrical power system 200 includes a number of sensors located therein. In this example, the system includes current sensors ; voltage sensors 284 (indicated by the solid triangles); and temperature sensors 386 (indicated by the solid rectangles). Here, the current sensors are implemented as Rogowski coils 382. Typically there are four current sensors: one on the upper (positive) side of the DC link; and one on each of the three phase connections 311a, 311c. In FIG. 3, there are typically five voltage sensors: two either side of the DC-link capacitor C1 (so as to measure the voltage drop across the capacitor); one on each of the three phase connections. There are typically four temperature sensors, one adjacent to each of the three phase legs 321a - 321c and one for measuring the temperature of the capacitor 328.

FIG. 4 is a schematic of a gate driver unit 340 including an integrated equipment health monitoring component 350 (also referred to as an electronic health monitoring integrated gate driver, or EHM-IGD). Overall, the gate driver unit, including the equipment health monitoring (EMH) component 350 is operable to measure the capacitor DC link current, the three-phase current of the power devices, and the phase-to-phase voltage of the power converter. The EHM component converts the raw measurements into degradation sensitive parameters for health monitoring. Typically, the EHM component can be thought of as the EHM processor shown in FIG. 4 together with the components of the gate driver unit 340 which collect data indicative of the health of the power electronics converter and/or components thereof.

In this example, the EHM-IGD includes an EHM processor which is connected to and receives data from: a gate driver and peak gate voltage unit; a fault detection unit; a voltage conditioning unit; a current conditioning unit; and a case temperature and core temperature unit. The gate driver and peak gate voltage unit is connected via terminal 420 to each of the semiconductor switching elements, so as to provide drive signals thereto and measure the peak gate voltage thereon. The fault detection unit is connected, via terminal 422, to one or more of the voltage sensors / Rogowski coils, and can be used to detect faults in one or more of the components of the power electronics converter. Therefore in some examples, the EHM processor does not detect faults itself, but rather receives information indicative of the determination of a fault from the fault detection unit. The voltage conditioning unit is also connected via terminal 422 to one or more of the voltage sensors via an isolator/clamper unit, and can be used to detect V_{don} (the voltage over a given switching element), V_{dc}, and Vₚₕₐₛₑ (the phase-to-phase voltage(s)). The current conditioning unit is connected via terminal 424 to one or more of the current sensors , and can be used to detect Iₚₕₐₛₑ (the current of one or more of the phase connections 311a - 311c) and I_{dc} (the current through the DC link).

The case temperature and core temperature unit is connected to one or more of the temperature sensors via terminal 426 and can be used to detect the temperature of the cases and/or heat sinks of one or more of the semiconductor switching elements and/or the DC-link capacitor core temperature. The measured temperatures, once sent to the EHM processor unit, can be used to estimate the power device junction temperature and the capacitor core temperature. These estimated temperatures can then be used to normalize the failure precursor parameters with respect to operating conditions.

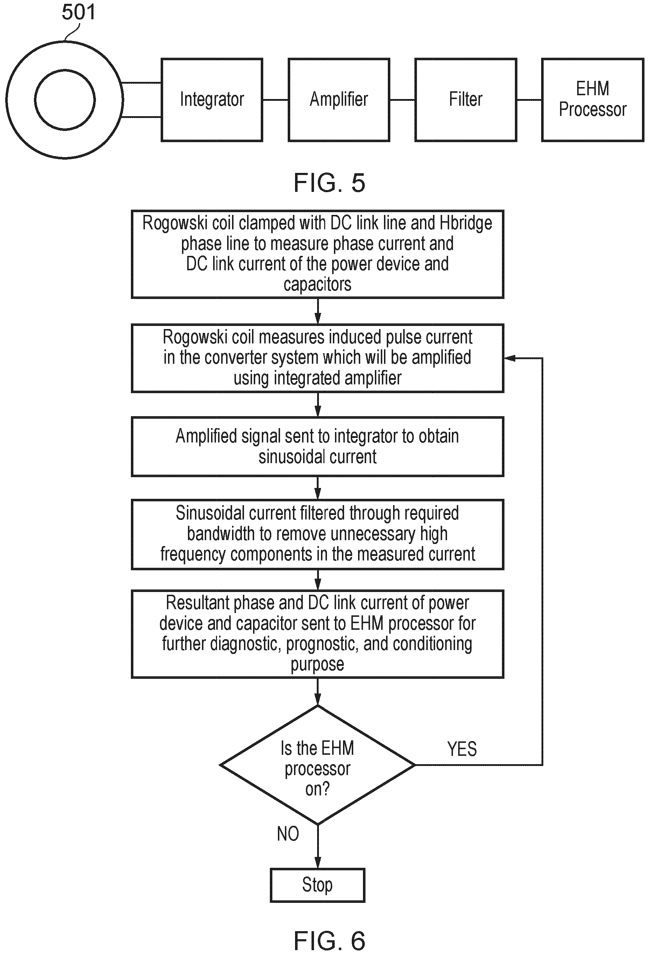

FIG. 5 is a schematic of a current sensor, which includes a Rogowski coil 501. During assembly of the power electronics converter, the Rogowski coil(s) are clamped onto the DC link line and the H-bridge phase lines (the phase connections 311a - 311c above), to measure the DC link current and phase current of the capacitors and power devices respectively. Once clamped, the Rogowski coils measure the induced pulse current in the power electronics converter. These measurements are then amplified using an integrated amplifier. Once the signal has been amplified it is sent to an integrator to obtain a proposed sinusoidal phase current or ripple current (or the signal is integrated and then sent to an amplifier, or the signal is processed in a single step through an integrator-amplifier), and the resultant sinusoidal current is passed through a filter which removes any unnecessary high frequency noise in the phase and DC-link current measurements.

Finally, the resultant phase and/or DC-link current measurements are sent to the EHM processor unit for further conditioning, diagnosis, or prognostic purposes. The Rogowski coil has no physical or direct connection with the power circuit, and so does not require any high voltage isolation. The coil PCB isolation is sufficient for the measurements.

FIG. 6 is a flow chart of the steps involved in measuring the phase and DC-link currents using the EHM-IGD disclosed herein. In a first step, the Rogowski coils are clamped with the DC link line and H-bridge phase lines respectively, to measure the phase current(s) and DC-link current of the power device and capacitors. Next, the Rogowski coils measure the induced phase currents in the converter system which are amplified using an integrated amplifier. The amplified signal is then sent to an integrator to obtain a sinusoidal current, and the sinusoidal current is then filtered through the required bandwidth to remove unnecessary high frequency components in the measured current. The resultant phase and DC-link current of the power device and capacitor is sent to the EHM processor for further prognostic, diagnostic, and conditioning purposes. The method moves to a decision point where it is determined if the EHM processor is ON, if so (YES), the method loops back to the measurement step and repeats. If not, (NO), the method stops.

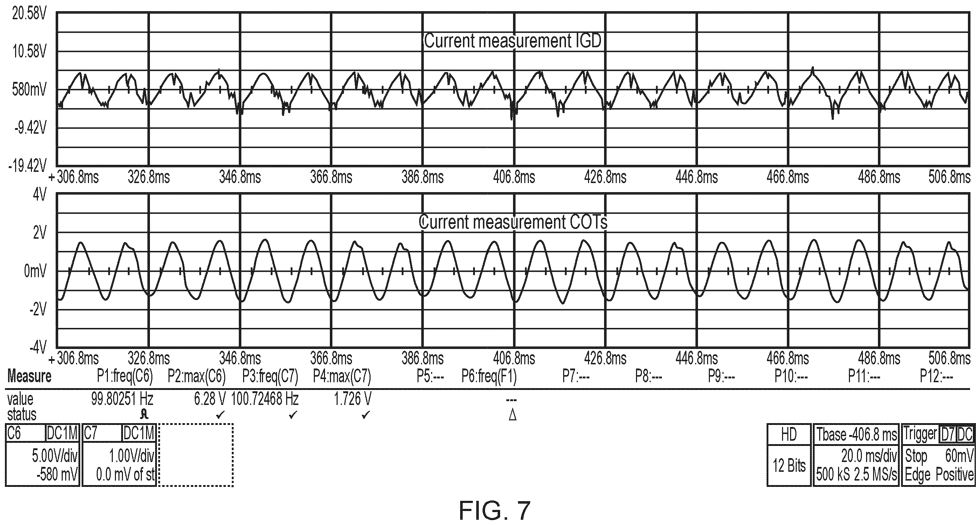

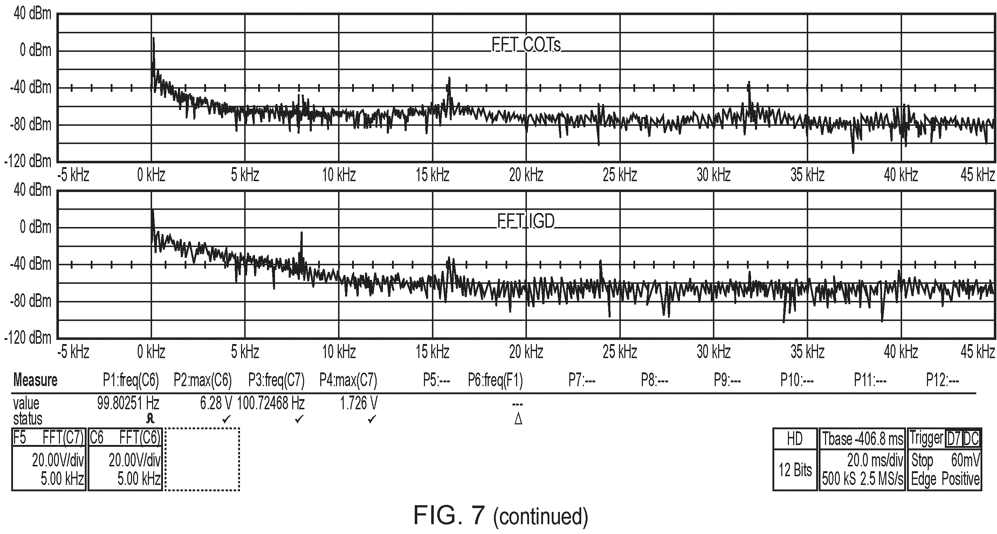

FIG. 7 shows the waveform of the phase current measurement and FFT spectrum obtained by the EHM-IGD and a commercial off-the-shelf (COTS) Rogowski current sensor. The test was performed at the fundamental frequency range of 100 Hz at a switching frequency of 8kHz for a load current of 34A. The performance of the Rogowski current sensor in the EHM-IGD was compared with a COTS current sensor at various fundamental frequencies, and the result confirmed that the Rogowski sensor in the EHM-IGD provided sufficient accuracy to enable equipment health monitoring of the electronic power converter and/or components thereof.

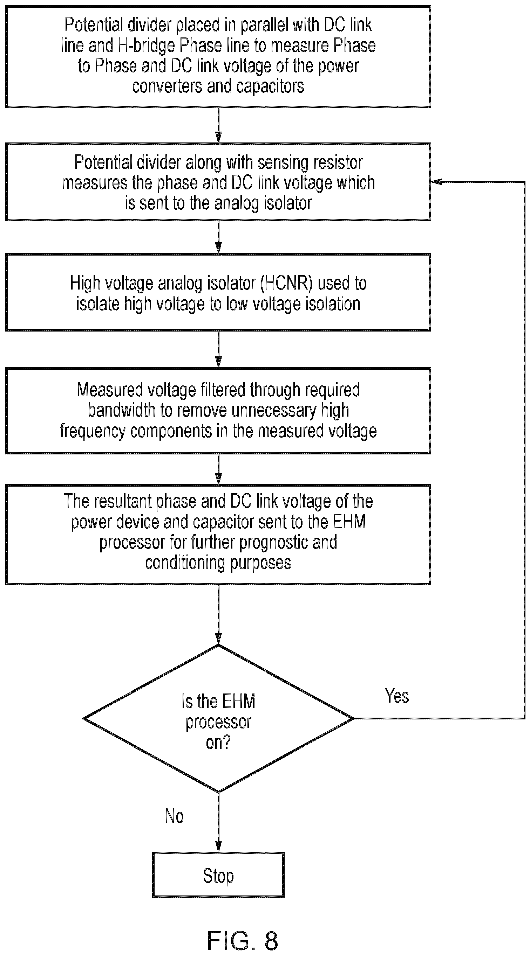

FIG. 8 is a flow chart of the steps involved in measuring the phase-to-phase and DC-link voltages using the EHM-IGD disclosed herein. The EHM-IGD uses a potential divider along with a sensing resistor to measure phase and DC link voltage. The potential divider is connected in series with a sensing resistor and is placed in parallel with the DC-link line and H-bridge phase line to measure the phase-to-phase voltage and DC-link voltage of the capacitor and power converter, respectively.

Here, a high voltage analog isolator is used to isolate the high voltage to low voltage side. After the signal isolation, the measured voltage is filtered through a predetermined frequency bandwidth to remove unnecessary low and high voltage ripples from the measured voltage signal. Finally, the resultant phase and DC link voltage is sent to the EHM processor for further conditioning or prognosis purposes.

As discussed above, the fault detection unit in FIG. 3 is connected to the or each current sensor (for example each Rogowski coil). In this example, the fault detection unit is connected to the Rogowski coil used to measure the phase current, and can be used by the fault detection unit to measure the fault current of the power module(s). However, unlike the phase current measurement discussed below, the measurement of the fault current does not use the integration unit. Instead, it has a filter and comparator unit to determine the presence of a fault current in the power circuit.

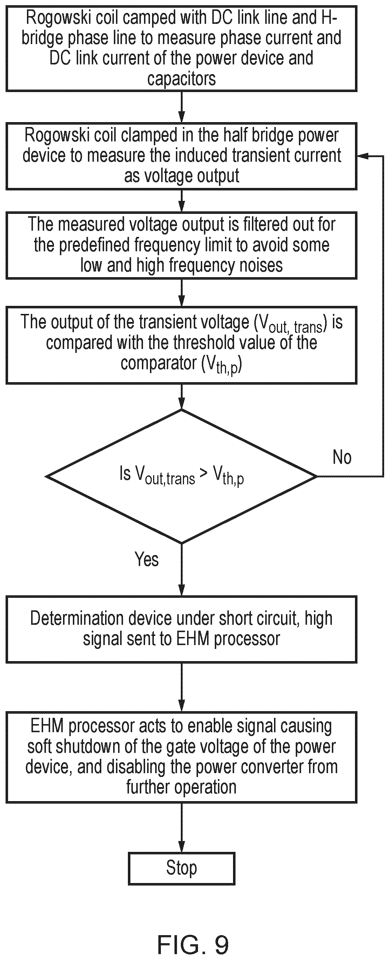

The Rogowski coil is clamped in the half bridge power device to measure the induced transient current as a voltage output. The output voltage is then filtered out for a predefined frequency limit to avoid the influence of low and high frequency signal noises. The output of the transient voltage (V_{out, trans}) is compared with the threshold value of the comparator (V_{th,p}). If the transient voltage is higher than the threshold, the device is under a short circuit fault and a high signal from the compactor enables the EHM processor to disable the gate pulse to the gate driver and enable a soft shutdown. This brings down the gate voltage of the power device, and also disables the gate pulse of all of the particular power leg (and enable a redundancy leg when present). If there is no redundancy leg present, then the EHM processor notifies the fault presence to the main controller for further operation of the power converter. FIG. 9 is a flow chart reflecting this.

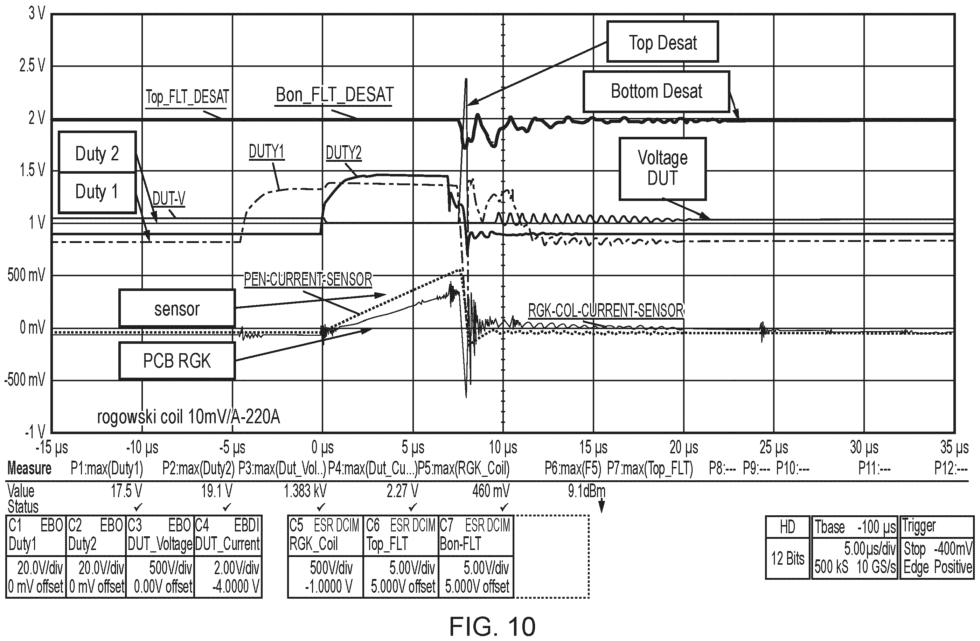

FIG. 10 shows a short circuit test experiment. As can be seen, the EHM-IGD is able to detect the rise in short circuit current faster than a commercially available DESAT (desaturation detector) with a huge margin. This increased margin is useful for wide band gap semiconductors (e.g., SiC) power modules as they are operated at very high switching frequencies.

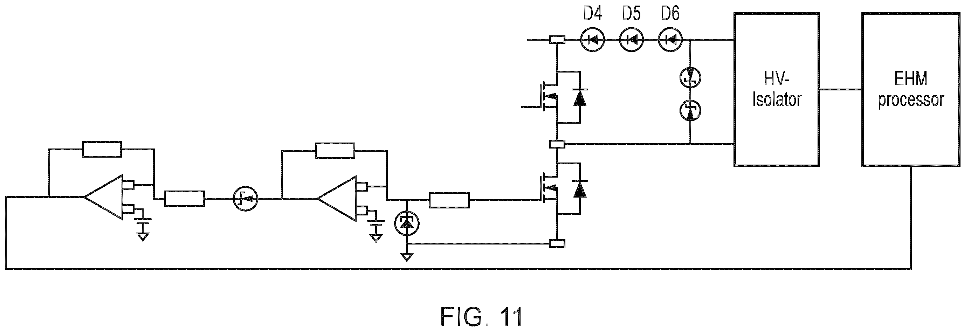

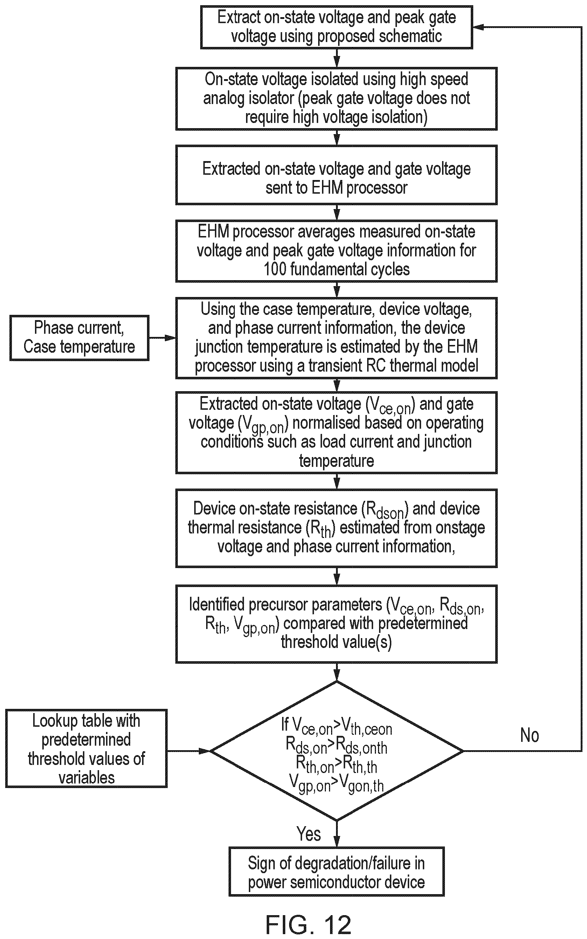

FIG. 11 is a block diagram of a component of the gate driver unit, and specifically the EHM-IGD power device prognostic unit. FIG. 12 is a flow chart representation of the EHM-IGD power device prognostic unit.

Initially, the power device on-state voltage and peak gate voltage are extracted using the IGD driver. The on-state voltage (V_{ce,on}) measurement is clamped to a predefined level, and then isolated using a high-speed voltage analog isolator. Similarly, the peak gate voltage (V_{gp,on}) is measured based on the schematic shown in FIG. 11. Once the peak gate voltage is measured, the information along with on-state voltage is sent to the EHM processor, where power device prognosis algorithms are implemented to extract the actual on-state and peak gate voltage.

In the EHM processor, the measured on-state voltage and peak gate voltage information are averaged for 100 fundamental cycles. The EHM processor then executes a transient RC thermal model to estimate the device steady state junction temperature (Tⱼ) using the measured case temperature (T_{c}), on-state voltage (V_{ce,on}), and phase current (Iₚₕ). Once the device junction temperature is estimated, the extracted on-state voltage (V_{ce,on}) and gate voltage (V_{gp,on}) are normalized based on operating conditions such as load current (Iₚₕ) and junction temperature (Tⱼ). After normalization the on-state voltage (V_{ce,on}) are used to estimate the phase current information, device on-state resistance (R_{dson}) and the device thermal resistance (Rₜₕ).

The identified parameters (V_{ce,on}, R_{ds,on}, Rₜₕₒₙ, V_{gp,on}) are compared with predetermined threshold values based on a device datasheet of parameters or historical power cycle data. In some examples, it is assumed that a 20% change from the initial value is a sign of device degradation, which may be referred to a device threshold limit (V_{ce,onth}, R_{ds,onth}, R_{th,th}, V_{gp,onth}). Finally, the EHM processor compares the normalized average precursor data with a threshold limit. If the values are below the threshold limit, the cycle repeats. If the values are higher, it is a sign of device degradation, and the information may be sent to a main controller for further decision making or action.

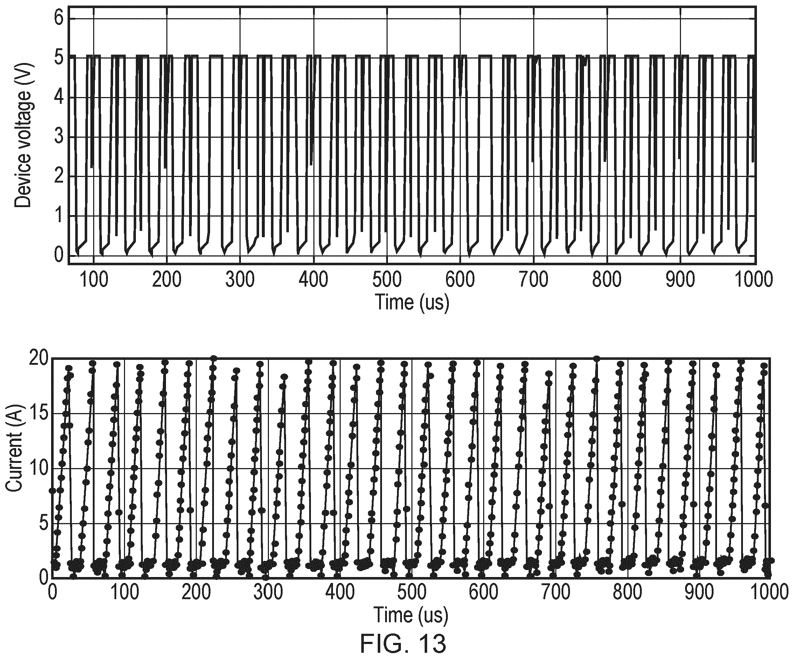

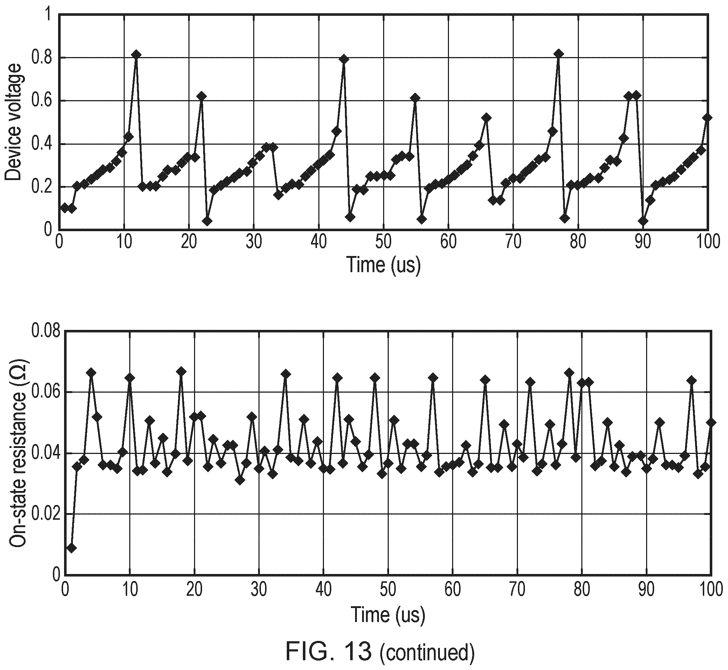

FIG. 13 shows typically acquired data for the on-state voltage, on-state resistance, and junction temperature of a power device. The data having been acquired by the EHM-IGD, and specifically an instrumentation and conditioning unit within the EHM-IG.

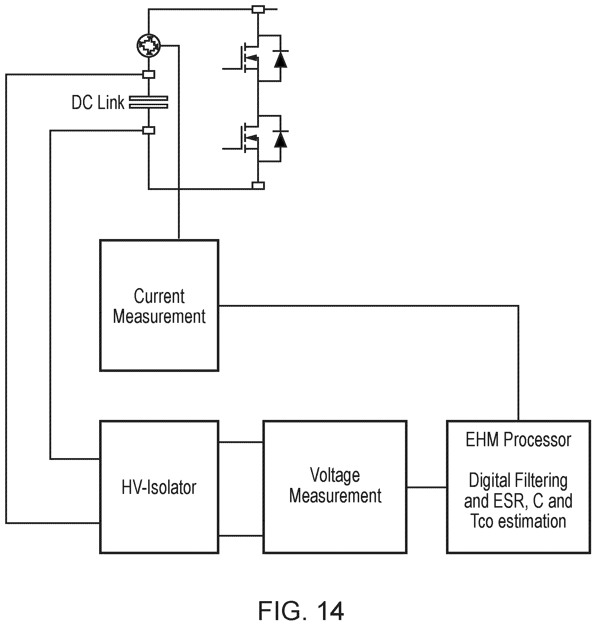

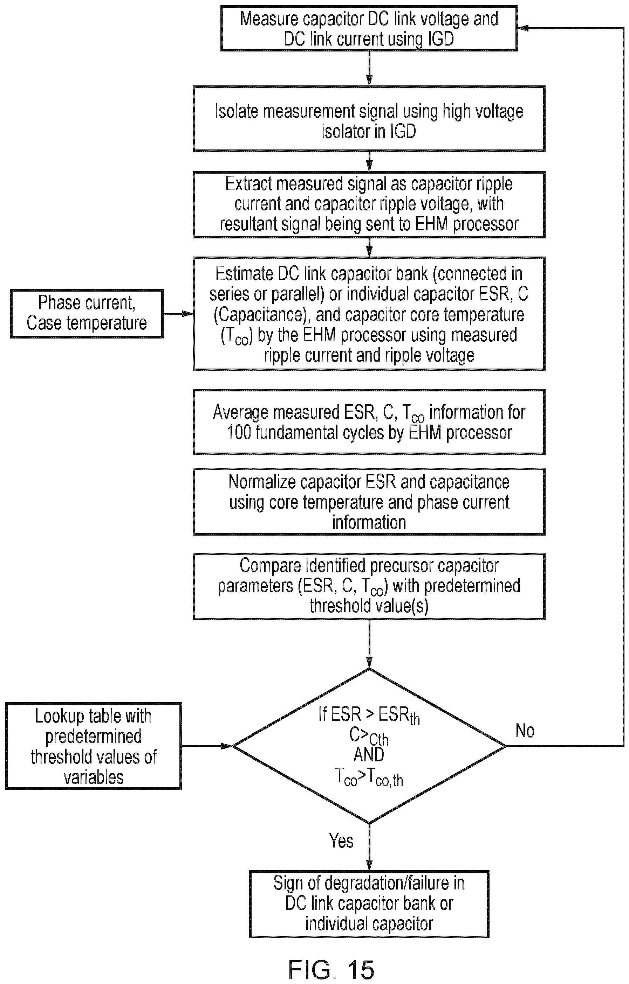

FIG. 14 is a block diagram of a component of the gate driver unit, and specifically an EHM-IGD DC-link capacitor prognostic unit. FIG. 15 is a flow chart illustrating its use in measuring the capacitor DC link voltage and DC link current. The capacitor ripple current and capacitor ripple voltage are extracted from the measured DC link current and voltages, and then sent to the EHM processor.

In the EHM processor, the DC link capacitor (connected in series or parallel) or individual capacitor ESR (external series resistance), C (capacitance) and capacitor core temperature (T_{co}) are estimated using the measured ripple current and ripple voltage. The measured ESR, C, and T_{co} information are averaged for 100 fundamental cycles, and then the averaged capacitor ESR and capacitance is normalized using the core temperature, frequency, voltage, and phase current information (as the ESR and capacitance is a function of temperature and voltage).

After normalization, the identified precursor capacitor parameters (ESR, C, T_{co}) are compared with predetermined threshold values based on device datasheet parameters or historical aged data. A change of 20% from the initial value may be considered as a sign of device degradation which is called the device threshold limit (ESRₜₕ, Cₜₕ, T_{co,th}). If the values are below the threshold limit, the cycle continues. If the values are higher than the threshold, it is a sign of DC link capacitor degradation, and the information may be sent to a main controller for further decision making or action.

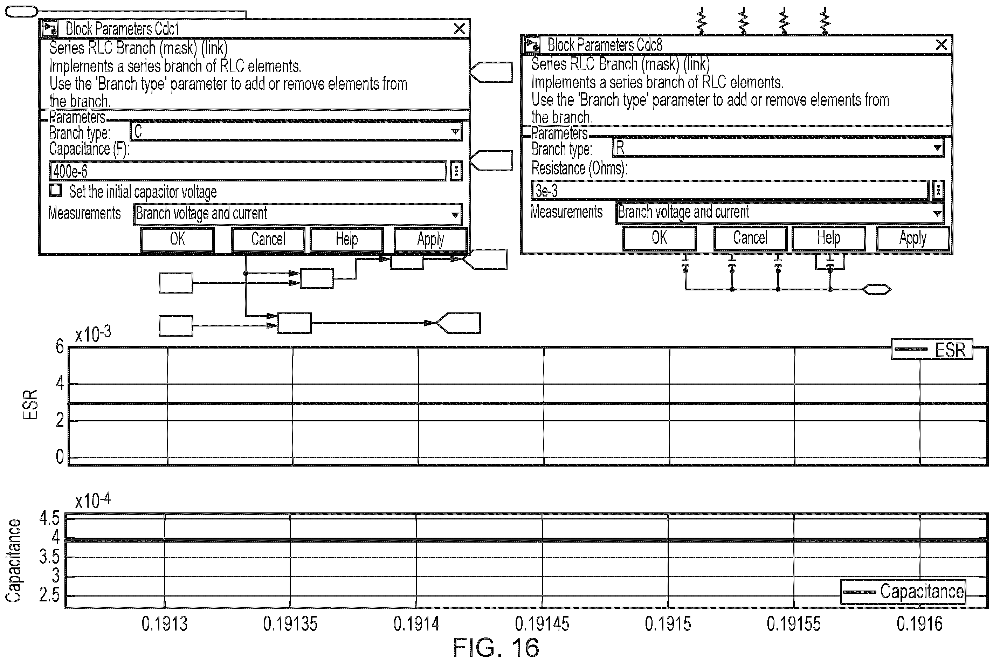

FIG. 16 shows experimental validation data of ESR and capacitance of the DC-link capacitor.

The systems and methods of the above embodiments may be implemented in a computer system (in particular in computer hardware or in computer software) in addition to the structural components and user interactions described.

The term "computer system" includes the hardware, software and data storage devices for embodying a system or carrying out a method according to the above described embodiments. For example, a computer system may comprise a central processing unit (CPU), input means, output means and data storage. The computer system may have a monitor to provide a visual output display. The data storage may comprise RAM, disk drives or other computer readable media. The computer system may include a plurality of computing devices connected by a network and able to communicate with each other over that network.

The methods of the above embodiments may be provided as computer programs or as computer program products or computer readable media carrying a computer program which is arranged, when run on a computer, to perform the method(s) described above.

The term "computer readable media" includes, without limitation, any non-transitory medium or media which can be read and accessed directly by a computer or computer system. The media can include, but are not limited to, magnetic storage media such as floppy discs, hard disc storage media and magnetic tape; optical storage media such as optical discs or CD-OMs; electrical storage media such as memory, including RAM, ROM and flash memory; and hybrids and combinations of the above such as magnetic/optical storage media.

For the avoidance of any doubt, any theoretical explanations provided herein are provided for the purposes of improving the understanding of a reader. The inventors do not wish to be bound by any of these theoretical explanations.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.

## Claims

1. A power electronics converter (206, 207) connectable, on a DC-side, to a DC electrical network (210, 330) and either, on an AC-side, to an electrical machine (213, 310) coupled to a drive shaft of an engine or propulsor (216, 204), or, on a second DC-side, to a battery pack (203), the power electronics converter including:
a power conversion unit (320) including a plurality of semiconductor switching elements (322, 324) and a DC-link (328); and
a gate driver unit (340), configured to control the semiconductor switching elements so that the power conversion unit: inverts DC power received from the DC electrical network (330) to AC power and provides the AC power to the electrical machine (310), rectifies AC power received from the electrical machine to DC power and provides the DC power to the DC electrical network, or performs DC-DC conversion between the DC electrical network and the battery pack;
wherein the gate driver unit (340) includes an equipment health monitoring component (350), configured to collect data indicative of the health of the power electronics converter and/or components thereof.

2. The power electronics converter of claim 1, wherein the equipment health monitoring component is configured to collect data indicative of one or more of:
an on-state voltage of the power conversion unit and/or components thereof;
a gate voltage of one or more of the plurality of semiconductor switching elements;
a temperature of the power conversion unit and/or components thereof;
a ripple voltage of a capacitor of the DC-link;
a ripple current of a capacitor of the DC-link;
a DC-link current;
a DC-link voltage;
a phase-to-phase voltage of the AC-side; and
a phase current in the AC-side.

3. The power electronics converter of claim 1 or claim 2, wherein the equipment health monitoring component (350) is configured to:
utilise the collected data to prognosticate the health of the power electronics converter and/or components thereof; and/or
utilise the collected data to diagnose faults in the power electronics converter and/or components thereof.

4. The power electronics converter of claim 3, wherein prior to utilising the collected data the equipment health monitoring component is configured to pre-process the collected data.

5. The power electronics converter of claim 3 or 4, wherein the equipment health monitoring component (350) is configured to take remedial action based on the prognostication and/or diagnosis of a fault.

6. The power electronics converter of any preceding claim, further including one or more sensors which generate the data collected by the equipment health monitoring component.

7. The power electronics converter of claim 6, wherein the one or more sensors include one or more of:
a first current sensor, located on the DC side of the power electronics converter and configured to sense current flowing therethrough;
a second current sensor, located on the AC side of the power electronics converter and configured to sense current flowing therethrough;
a first voltage sensor, located on the DC side of the power electronics converter and configured to sense a voltage of the DC side;
a second voltage sensor, located on the AC side of the power electronics converter and configured to sense a voltage of the AC side;
a first temperature sensor located proximal to one or more of the semiconductor switching elements, configured to measure a temperature of a heatsink thereof; and
a second temperature sensor, located proximal to a capacitor of the DC-link, and configured to measure a temperature of a case thereof.

8. The power electronics converter of claim 7, wherein the first and/or second current sensors are indirect current sensors.

9. The power electronics converter of any preceding claim, wherein the equipment health monitoring component (350) is configured to utilise the collected data to derive further data related to the power electronics converter and/or components thereof.

10. The power electronics converter of claim 8, wherein the equipment health monitoring component (350) is configured to use one or more measured temperatures to derive one or both of an estimated junction temperature of the or each semiconductor switching element and a core temperature of a capacitor of the DC-link.

11. An electrical power system (300) comprising:
an electrical machine (111, 113, 213, 310) coupled to a drive shaft (214) of an engine (101, 204); and/or
a battery pack (203);
the electrical power system further comprising:
a DC electrical network (210, 330); and
the power electronics converter (206, 207) of any of claims 1 to 10, connected on the DC-side to the DC electrical network (210, 330) and either, on the AC-side, to the electrical machine (111, 113, 213, 310) or, on the second DC-side, to the battery pack (203).

12. An aircraft power and propulsion system comprising:
the electrical power system (300) according to claim 11, wherein the electrical machine (310) of the electrical power system (300) is mechanically coupled with a fan (216).

13. An aircraft comprising the power and propulsion system of claim 12.

14. A method of controlling an electrical power system (300), the electrical power system (300) comprising:
an electrical machine (310), and/or
a battery pack (203),
the electrical power system further comprising: a DC electrical network (330), and
a power electronics converter (206, 207) connected between either the electrical machine and the DC electrical network or the battery pack and the DC electrical network,
the method comprising:
controlling, by a gate driver unit (340), the switching of semiconductor switching elements (322, 324) of a power conversion unit (320) of the power electronics converter (206, 207) to: invert a DC input from the DC electrical network to an AC output and supply the AC output to the electrical machine (310), rectify an AC power received from the electrical machine to DC power and provide the DC power to the DC electrical network, or perform DC-DC conversion between the DC electrical network and the battery pack; and
collecting, by an equipment health monitoring component (350) which forms a part of the gate driver unit (340), data indicative of the health of the power electronics converter and/or components thereof.

15. A gate driver unit (340) for an electrical power system (330) configured to:
control switching of a plurality of semiconductor switching elements (322, 324) of a power conversion unit (320) of a power electronics converter (206, 207) so as to:
invert DC power received by the power electronics converter from a DC electrical network to AC power and provide the AC power to an electrical machine (310);
rectify AC power received from the electrical machine to DC power and provide the DC power to the DC electrical network; or
perform DC-DC conversion between the DC electrical network a battery pack;
the gate driver unit further comprising an equipment health monitoring component (350) configured to collect data indicative of the health of the power electronics converter and/or components thereof.
